# EUROPEAN PATENT APPLICATION

(11) **EP 4 310 904 A1**
(43) Date of publication of application: **24.01.2024**
(21) Application number: 22807158.5
(22) Date of filing: 14.03.2022
(51) Int. Cl.: H01L 23/36, H05K 7/20

(54) **HEAT SINK AND HEAT SINK PRODUCTION METHOD**

(30) Priority: 10.05.2021 JP 2021079493
(71) Applicant: Nippon Light Metal Co., Ltd., Minato-ku Tokyo 105-0004 (JP)
(72) Inventor: NAKAMURA, Takumi, Tokyo 105-0004 (JP); KUWAHARA, Kazuhiro, Shizuoka-shi, Shizuoka 421-3203 (JP); TAKAGI, Yasushi, Shizuoka-shi, Shizuoka 421-3297 (JP); IISAKA, Hitoshi, Shizuoka-shi, Shizuoka 421-3297 (JP)
(74) Representative: Kiwit, Benedikt
(86) International application number: PCT/JP2022/011240
(87) International publication number: WO 2022/239451

(57) **Abstract**

Slits includes a plurality of first slits (21) arranged to be straight on a base (2) and a plurality of second slits (22) arranged to be straight on the base (2) and intersecting the first slits (21), each pin fin (3) includes a pin-fin lower portion (10) being continuous with and standing on the base (2) and a pin-fin upper portion (11) being continuous with and extending from the pin-fin lower portion (10), and slit widths (W2) of the first slits (21) and the second slits (22), the slit widths (W2) corresponding to the pin-fin upper portions (11), are greater than slit widths (W1) of the first slits (21) and the second slits (22), the slit widths (W1) corresponding to the pin-fin lower portion (10).

## Description

### TECHNICAL FIELD

The present invention relates to a heat sink and a heat sink production method.

### BACKGROUND ART

Liquid cooled or air cooled heat sinks, which are used for cooling semiconductors or the like, include pin fins (pin-shaped fins) to extend heat transfer surfaces. For example, Patent Literature 1 discloses a method for producing a heat sink including pin fins having rhombic cross sections. In this heat sink production method, a multi-cutter including layered disc cutters (metal saws) is used to cut a metal workpiece block. In this process, the multi-cutter is moved such that slits formed by cutting intersect one another, thereby forming pin fins having rhombic cross sections.

### CITATION LIST

### Patent Literature

Patent Literature 1: JP2013-254772A

### SUMMARY OF INVENTION

### Technical Problem

In a conventional method for producing a heat sink, it is conceivable that cutting is repeated in two or more steps while the insertion depth of the multi-cutter is increased, to form taller pin fins. However, in such a method, disc cutters can come into contact with pin fins under formation, causing deformation and damage to the pin fins. Thus, it is difficult to form taller pin fins. Since it is difficult to produce larger heat sinks with taller pin fins, applications of pin-fin structures are limited to relatively small liquid cooled heat sinks. Hence, heat sinks that have taller pin fins, can be larger in size, and can also be used for air cooling are desired.

From the above viewpoint, an object of the present invention is to provide a heat sink and a heat sink production method that make it possible to achieve high formation accuracy and easily form taller pin fins.

### Solution to Problem

A heat sink to solve the above problem includes: a plate-shaped base; a plurality of pin fins separately standing on the base; and a plurality of slits located between the plurality of pin fins to separate the plurality of pin fins, in which the slits includes a plurality of first slits arranged to be straight on the base and a plurality of second slits arranged to be straight on the base and intersecting the first slits, each pin fin includes a pin-fin lower portion being continuous with and standing on the base and a pin-fin upper portion being continuous with and extending from the pin-fin lower portion, and slit widths of the first slits and the second slits, the slit widths corresponding to the pin-fin upper portions, are greater than slit widths of the first slits and the second slits, the slit widths corresponding to the pin-fin lower portion.

The pin-fin lower portion and the pin-fin upper portion form a stepped shape in side view, and a fin width of the pin-fin upper portion may be less than a fin width of the pin-fin lower portion.

A cross section of the pin-fin lower portion and a cross section of the pin-fin upper portion may have similar shapes.

An axial center of the pin-fin lower portion may be aligned with an axial center of the pin-fin upper portion.

An axial center of the pin-fin lower portion and an axial center of the pin-fin upper portion may be shifted from each other.

A difference between a fin width of the pin-fin lower portion and a fin width of the pin-fin upper portion maybe 0.1 mm or more.

A dimension of a step between the pin-fin lower portion and the pin-fin upper portion may be 0.05 mm or more.

A difference between a fin width of the pin-fin lower portion and a fin width of the pin-fin upper portion may be 1% or more of the fin width of the pin-fin lower portion.

A fin width of each pin fin may be 2 to 20 mm.

A width of each slit may be 0.5 to 10 times a fin width of the pin fin.

A height dimension of each pin fin may be 1 to 300 mm.

The present invention is a method for producing a heat sink including a plurality of pin fins, including: a first-stage processing step of cutting a workpiece block from an end surface of the workpiece block to a position at a specified depth to form a plurality of intersecting slits; and a second-stage processing step of cutting, after the first-stage processing step, the workpiece block to a position deeper than the position of the first-stage processing step to form a plurality of intersecting slits, thereby forming the plurality of pin fins, in which widths of the slits formed by cutting in the first-stage processing step are set greater than widths of the slits formed by cutting in the second-stage processing step.

The method may further include a cut-off step of removing, before the first-stage processing step, a portion including a side surface of the workpiece block in an area of a peripheral edge portion of the workpiece block, the area being where the slits are not to be formed.

In at least one of the first-stage processing step and the second-stage processing step, cutting may be performed in two or more steps, each with a different insertion depth from the end surface of the workpiece block.

After the plurality of intersecting slits are formed in the first-stage processing step, the plurality of intersecting slits may be formed in the second-stage processing step.

### Advantageous Effects of Invention

The heat sink and the heat sink production method according to the present invention make it possible to achieve high formation accuracy and easily form taller pin fins.

### BRIEF DESCRIPTION OF DRAWINGS

FIG. 1 is a perspective view of a heat sink according to a first embodiment of the present invention.
FIG. 2 is an enlarged perspective view of a pin fin according to the first embodiment.
FIG. 3 is a plan view of the heat sink according to the first embodiment.
FIG. 4 is a side view of the heat sink according to the first embodiment in a P direction.
FIG. 5 is a side view of the heat sink according to the first embodiment in a Q direction.
FIG. 6 is a plan view of a multi-cutter used in a heat sink production method according to the first embodiment of the present invention.
FIG. 7 is a front view of a disc cutter used in the heat sink production method according to the first embodiment.
FIG. 8 is an enlarged plan view of the multi-cutter used in the heat sink production method according to the first embodiment.
FIG. 9 is a perspective view diagram illustrating a preparation step of the heat sink production method according to the first embodiment.
FIG. 10 a perspective view diagram illustrating a cut-off step of the heat sink production method according to the first embodiment.
FIG. 11 is a side view diagram illustrating a first step of a first-stage processing step of the heat sink production method according to the first embodiment.
FIG. 12 is a side view diagram illustrating a second step of the first-stage processing step of the heat sink production method according to the first embodiment.
FIG. 13 is a side view diagram illustrating a first step of a second-stage processing step of the heat sink production method according to the first embodiment.
FIG. 14 is a side view diagram illustrating a second step of the second-stage processing step of the heat sink production method according to the first embodiment.
FIG. 15 is a side view diagram illustrating a first pass of a first step of a first-stage processing step of a heat sink production method according to a second embodiment.

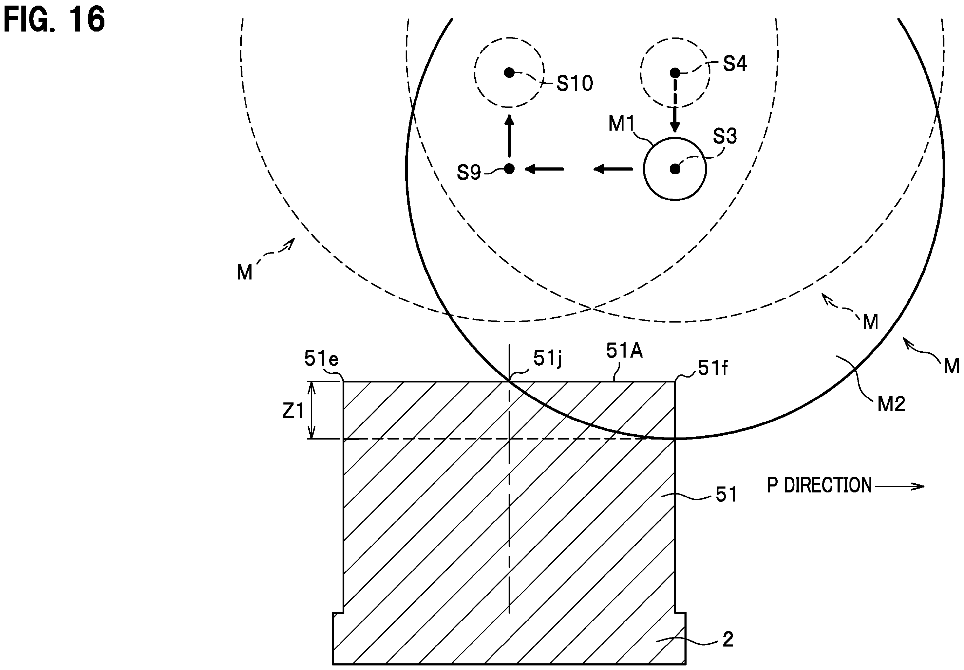

FIG. 16 is a side view diagram illustrating a second pass of the first step of the first-stage processing step of the heat sink production method according to the second embodiment.
FIG. 17 is a perspective view of an insertion jig used in a heat sink production method according to a third embodiment.
FIG. 18 is a plan view diagram of a second-stage processing step of the heat sink production method according to the third embodiment.
FIG. 19 is a side view diagram of the second-stage processing step of the heat sink production method according to the third embodiment.
FIG. 20 is a perspective view of a pin fin according to a first modification example.
FIG. 21 is a perspective view of a pin fin according to a second modification example.
FIG. 22 is a table showing evaluation test results.

### DESCRIPTION OF EMBODIMENTS

### [1. First Embodiment]

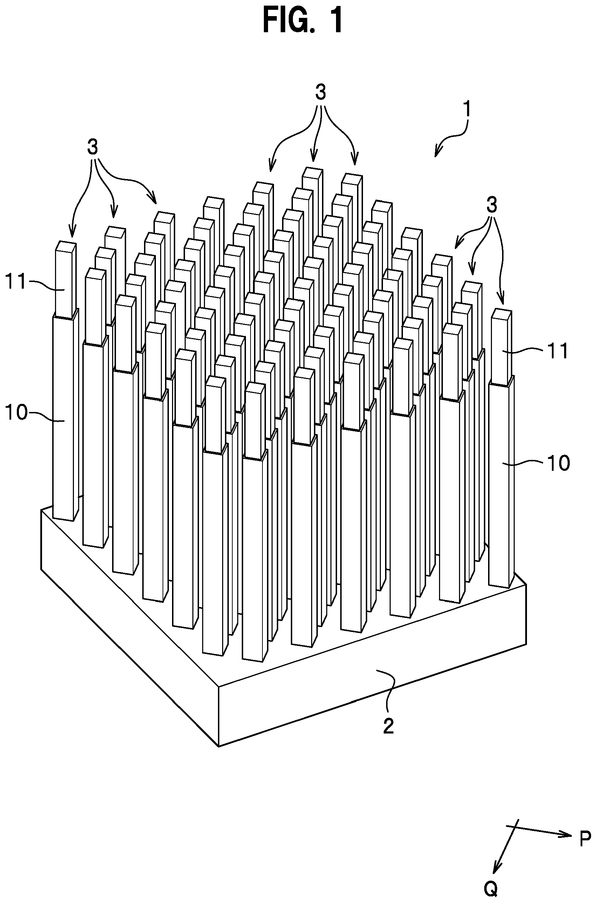

The first embodiment of the present invention will be described with reference to the drawings as necessary. The present invention is not limited only to the following embodiments. Part or all of the constituents in the embodiments and modification examples can be combined as appropriate. Reference signs are sometimes omitted for the same members. For convenience of explanation, the dimensions of each member depicted in the drawings differ from actual ones. In the following description, a P direction and a Q direction are orthogonal to each other in a horizontal plane and are defined by the arrows in FIG. 1.

As shown in FIG. 1, a heat sink 1 according to a first embodiment of the present invention includes a base 2 and a plurality of pin fins 3 separately standing on the base 2. The heat sink 1 is a member for cooling a heat generation element such as a semiconductor by causing a liquid or a gas to flow between the pin fins 3. The number of pin fins 3 for the base 2 is a mere example and may be set as appropriate.

The heat sink 1 is integrally formed by cutting a metal member. The material of the heat sink 1 is not limited, as long as it can be subjected to cutting, and is, for example, aluminum, an aluminum alloy, copper, a copper alloy, and the like. Note that the heat sink 1 may be made of a composite member containing a metal, a ceramic, a resin, or the like.

From the viewpoint of heat conduction, the metal material forming the heat sink 1 should preferably be at least one kind selected from the group consisting of aluminum, aluminum alloys, copper, and copper alloys. From the viewpoint of heat conduction and lightweight, the metal material forming the heat sink 1 should preferably be at least one kind selected from the group consisting of aluminum and aluminum alloys. The aluminum alloy used for this is not particularly limited, and from the viewpoint of processability, for example, aluminum alloys in 1000 series, 3000 series, 5000 series, and 6000 series can be suitably used. Among these aluminum alloys, for example, A1050, A3003, A5052, and A6063 can be used.

The base 2 is plate-shaped. The base 2 in the present embodiment is rectangular in plan view. The pin fins 3 stand perpendicularly to the base 2. The pin fins 3 are portions that make contact with a refrigerant such as a liquid and a gas flowing through the slits (gaps) between the pin fins 3.

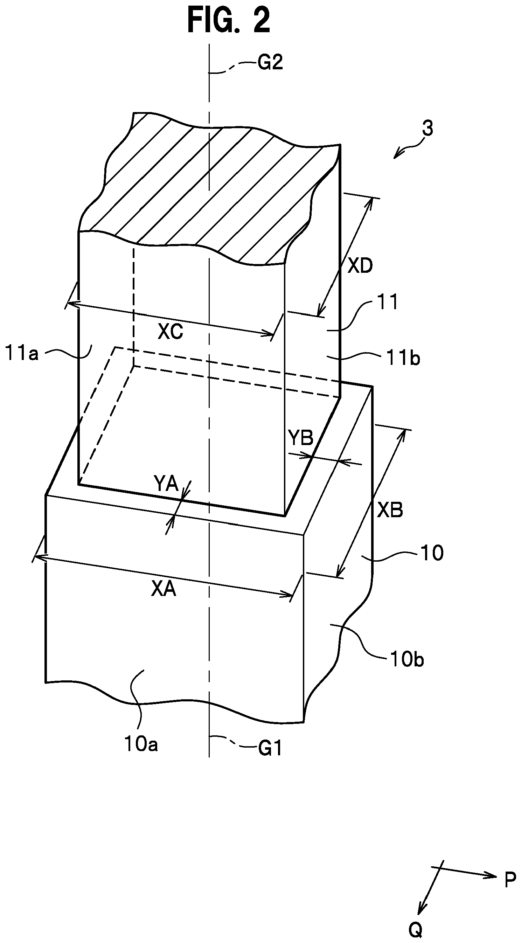

As also shown in FIG. 2, each pin fin 3 is an elongated rectangular parallelepiped and includes a pin-fin lower portion 10 continuous with the base 2 and a pin-fin upper portion 11 continuous with and extending from the pin-fin lower portion 10. In the pin fin 3, the pin-fin upper portion 11 is a little narrower than the pin-fin lower portion 10. The length of the pin-fin upper portion 11 (the length of the pin fin upper portion 11 relative to the entire pin fin 3) may be set as appropriate.

The cross sections of the pin-fin lower portion 10 and the pin-fin upper portion 11 have both square shapes in the present embodiment. The cross sections of the pin-fin lower portion 10 and the pin-fin upper portion 11 have similar shapes in the present embodiment. Note that "cross section" in this specification denotes one on a plane perpendicular to the height direction (axis direction) of the pin fin 3 standing on the base 2. The axis (axial center) G1 of the pin-fin lower portion 10 is aligned with the axis (axial center) G2 of the pin-fin upper portion 11.

Accordingly, in the present embodiment, the fin widths XA and XB of the pin-fin lower portion 10 are equal, and the fin widths XC and XD of the pin-fin upper portion 11 are equal. The difference between the fin width XA (XB) of the pin-fin lower portion 10 and the fin width XC (XD) of the pin-fin upper portion 11 may be set to 0.1 mm or greater as appropriate.

In the present embodiment, the dimension YA of the step between a side surface 10a of the pin-fin lower portion 10 and a side surface 11a of the pin-fin upper portion 11 is equal to the dimension YB of the step between a side surface 10b of the pin-fin lower portion 10 and a side surface 11b of the pin-fin upper portion 11. For example, in the case in which the difference between the fin width XA (XB) of the pin-fin lower portion 10 and the fin width XC (XD) of the pin-fin upper portion 11 is o.1 mm, the dimensions YA and YB of the steps are both 0.05 mm. The dimensions YA and YB of the steps may be set as appropriate and may be equal or different.

Although the difference between the fin width XA (XB) of the pin-fin lower portion 10 and the fin width XC (XD) of the pin-fin upper portion 11 may be set as appropriate, it is set in the present embodiment to, for example, 1% or more of the fin width XA (XB) of the pin-fin lower portion 10. In other words, these fin widths are set such that the fin width XC (XD) of the pin-fin upper portion 11 is 99% or less of the fin width XA (XB) of the pin-fin lower portion 10.

The fin width XA (XB) of the pin fin 3 is 2 to 20 mm, preferably 2.5 to 10 mm, or more preferably 3 to 8 mm. The height dimension of the pin fin 3 is 1 to 300 mm, preferably 10 to 200 mm, or more preferably 20 to 150 mm. The variations of the pin fin 3 will be described later.

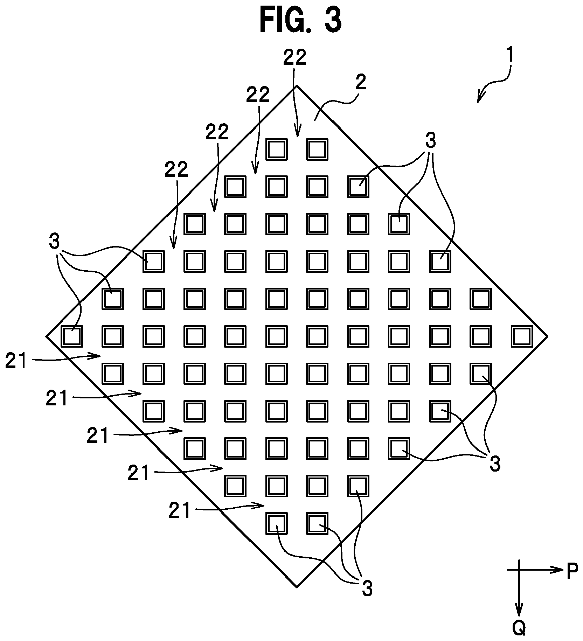

As shown in FIG. 3, a plurality of slits (gaps) are formed between adjacent pin fins 3,3. In the present embodiment, the slits extending in the P direction are referred to first slits 21, and the slits extending in the Q direction orthogonal to the P direction are referred to as second slits 22. Each of the first slits 21 has the same width and is straight and parallel to the others. Each of the second slits 22 has the same width and is straight and parallel to the others. The plurality of second slits 22 intersect the plurality of first slits 21. Although the widths of the first slit 21 and the second slit 22 may differ from each other, they are equal in the present embodiment. The pin fins 3 are arranged in a lattice shape in the present embodiment. The heat sink 1 of the present embodiment includes only the pin fins 3 having a square cross section and does not include pin fins located in peripheral edge portions of the base 2 and having triangular or pentagonal cross sections in which some part is missing from the square.

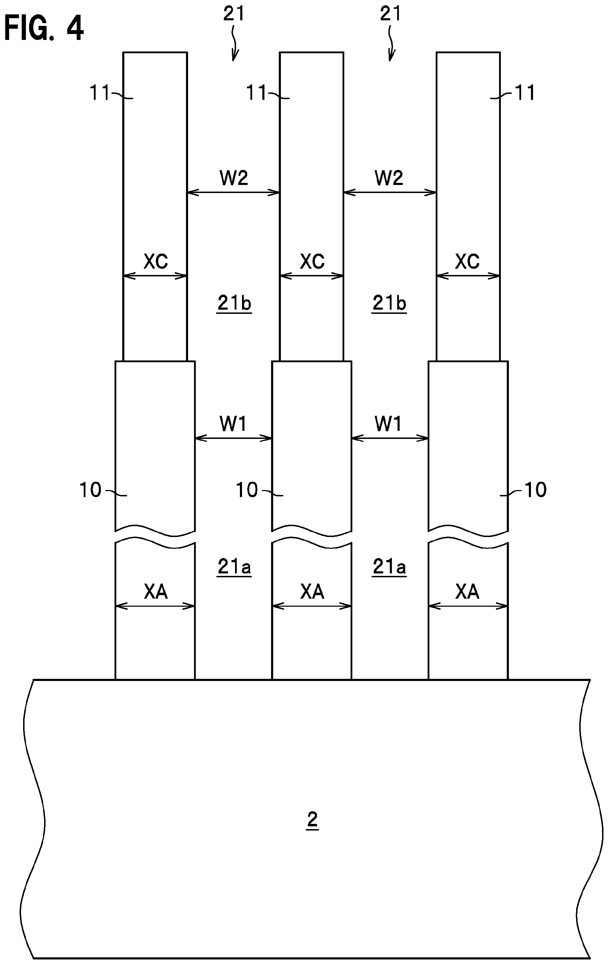

FIG. 4 is a side view of the heat sink according to the first embodiment in the P direction. As shown in FIG. 4, the first slit 21 includes a first-slit lower portion 21a and a first-slit upper portion 21b. The slit width W2 of the first-slit upper portion 21b is greater than the slit width W1 of the first-slit lower portion 21a. Each of the slit widths W1 and W2 is constant regardless of the height.

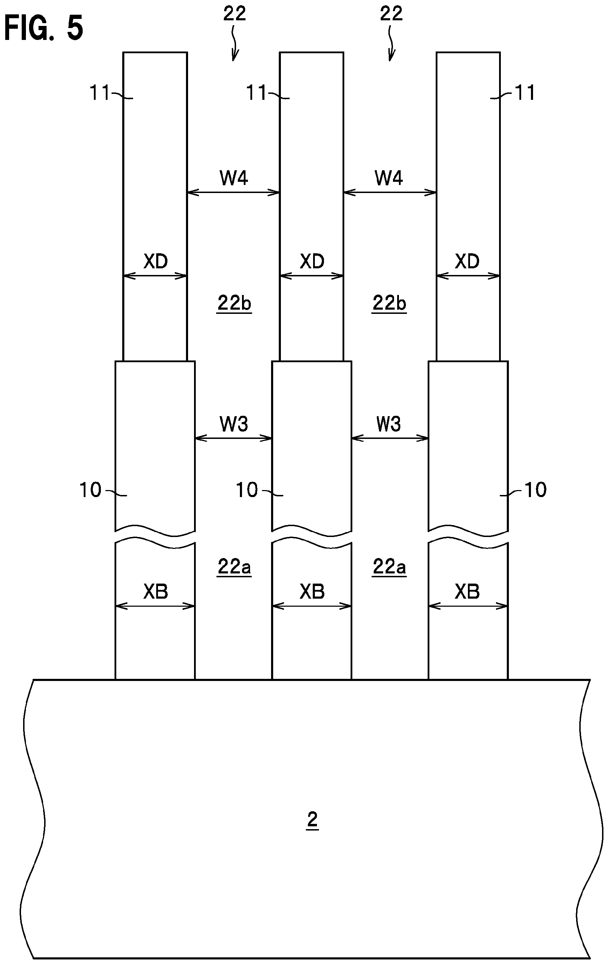

FIG. 5 is a side view of the heat sink according to the first embodiment in the Q direction. As shown in FIG. 5, the first slit 22 includes a second-slit lower portion 22a and a second-slit upper portion 22b. The slit width W4 of the second-slit upper portion 22b is greater than the slit width W3 of the second-slit lower portion 22a. Each of the slit widths W3 and W4 is constant regardless of the height.

Although the slit width W1 of the first-slit lower portion 21a and the slit width W3 of the second-slit lower portion 22a may have different dimensions, they have the same dimensions in the present embodiment.

Similarly, although the slit width W2 of the first-slit upper portion 21b and the slit width W4 of the second-slit upper portion 22b may have different dimensions, they have the same dimensions in the present embodiment.

Although the widths of the slits and the fin widths of the pin fin 3 may be set as appropriate, for example, the slit width W1 of the first-slit lower portion 21a should preferably be 0.5 to 5 times, more preferably be 0.8 to 4 times, or still more preferably be 1 to 3 times the fin width XA of the pin fin 3. In addition, for example, the slit width W2 of the first-slit upper portion 21b should preferably be 0.5 to 10 times, more preferably be 0.8 to 8 times, or still more preferably be 1 to 5 times the fin width XC of the pin fin 3.

The relationship between the pin fin 3 and the slit can be summarized as follows.

Each pin fin 3 is arranged to be surrounded by first slits 21 adjacent to each other and second slits 22 adjacent to each other.

Each pin-fin lower portion 10 and each pin-fin upper portion 11 have a pillar shape with a quadrangular cross section consisting of a set of opposed sides parallel to each other and another set of opposed sides parallel to each other and intersecting the set of opposed sides. In the set of opposed sides, the side surface 10a of the pin-fin lower portion 10 and the side surface 11a of the pin-fin upper portion 11 face the first slit 21. In the other set of opposed sides, the side surface 10b of the pin-fin lower portion 10 and the side surface 11b of the pin-fin upper portion 11 face the second slit 22. The side surface 10a (10b) of the pin-fin lower portion 10 and the side surface 11a (11b) of the pin-fin upper portion 11 are parallel to each other.

Next, a heat sink production method according to the first embodiment of the present invention will be described. The heat sink production method includes a preparation step, a cut-off step, a first-stage processing step, and a second-stage processing step.

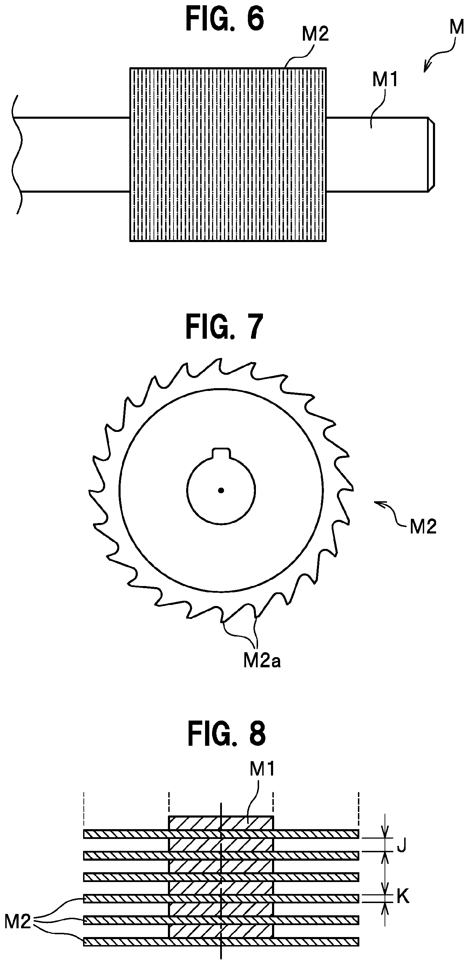

First, a multi-cutter used in the first-stage processing step and the second-stage processing step will be described. As shown in FIG. 6, a multi-cutter M used in the first-stage processing step includes a shaft M1 and a plurality of disc cutters M2 layered at intervals. The multi-cutter M is a device in which the shaft M1 and the disc cutters M2 rotate and that cuts a metal member and is capable of forming a plurality of plate-shaped members (for example, fins) simultaneously. When a rotating multi-cutter M is inserted into a metal member to cut it, the cutting may be performed by down cutting or up cutting.

As shown in FIG. 7, each disc cutter M2 is circular and has a plurality of blades M2a in the peripheral edge. As shown in FIG. 8, adjacent disc cutters M2 are arranged at equal intervals with a gap J in between. The dimensions of the fin widths XA, XB, XC, and XD of the pin fin 3 can be defined by the dimension of the gap J. The dimensions of the slit widths W1, W2, W3, and W4 of the first slit 21 and the second slit 22 can be defined by the thickness K of the disc cutter M2. In the present embodiment, the thickness K of the disc cutter M2 is equal to the slit width W2 of the first-slit upper portion 21b and the slit width W4 of the second-slit upper portion 22b.

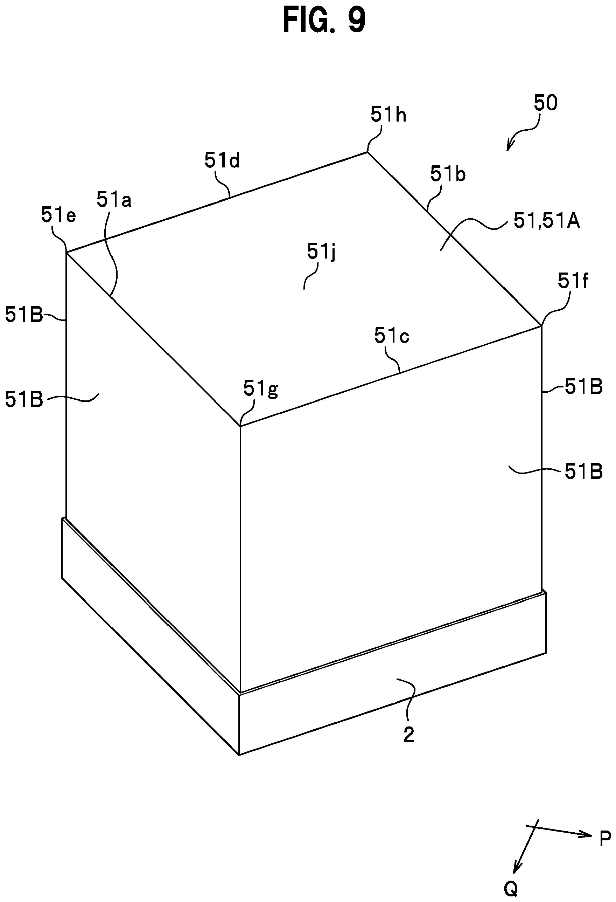

As shown in FIG. 9, the preparation step is a step of preparing a workpiece block 50. The workpiece block 50 includes the base 2 and a block portion 51, which are integrally formed. The block portion 51 has a cubic shape. The block portion 51 includes an end surface (the upper surface) 51A and four side surfaces 51B. The sides defining the end surface 51A of the block portion 51 are referred to as sides 51a, 51b, 51c, and 51d. The apexes of the block portion 51 are referred to as apexes 51e, 51f, 51g, and 51h.

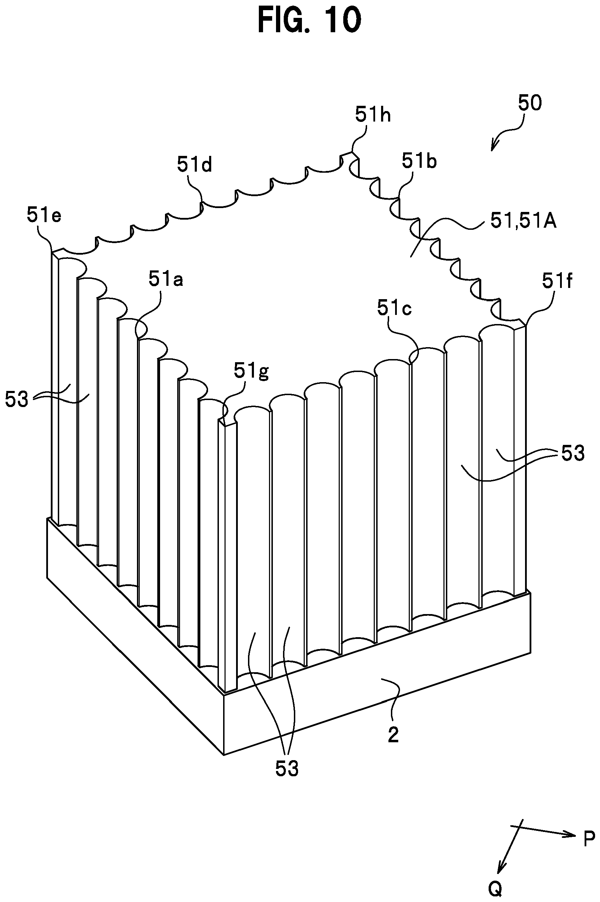

As shown in FIG. 10, the cut-off step is a step of cutting and shaving each side surface 51B of the block portion 51. A plurality of semi-cylindrical recesses 53 parallel to the height direction are formed in each side surface 51B. The recesses 53 can be formed by, for example, cutting by using an end mill. The recesses 53 are formed around the entire periphery of the block portion 51 in the present embodiment. The depth of each recess 53 is equal to the final total length of the pin fin 3, in other words, the sum of the height dimension of the pin-fin upper portion 11 and the height dimension of the pin-fin lower portion 10.

Without the cut-off step, irregular pin fins are formed on the edges of the base 2 in some cases after the first-stage processing step and the second-stage processing step are performed. An irregular pin fin has at least two side surfaces facing the first slit 21 and the second slit 22 and the other side surface(s) not facing either the first slit 21 or the second slit 22. An irregular pin fin has part of (a) side surface(s) 51B of the workpiece block 50 before being cut, as the other side surface(s) not facing either the first slit 21 or the second slit 22. The cut-off step cuts and removes areas including positions where irregular pin fins can be formed in the peripheral edge portions of the workpiece block 50.

More specifically, in the peripheral edge portions of the workpiece block 50, the cut-off step cuts and removes the portions that are not subjected to cutting by the multi-cutter M in the first-stage processing step and the second-stage processing step, hence in which the first slits 21 and the second slits 22 are not formed, and that include part of a side surface 51B of the workpiece block 50. In this process, to be adapted to the arrangement intervals at which the pin fins 3 and irregular pin fins are formed, it is preferable to perform wavy processing or zigzag processing such that the side surface portions of the block portion (the workpiece block) 51 have wavy or zigzag shapes including repeated semicircles (segmental circles) or triangles in plan view. It is preferable to perform wavy processing or zigzag processing such that the height of the semicircles (segmental circles) or triangles from the peripheral edge ends of the workpiece block 50 is at least equal to the length of the diagonal line of the pin fin 3.

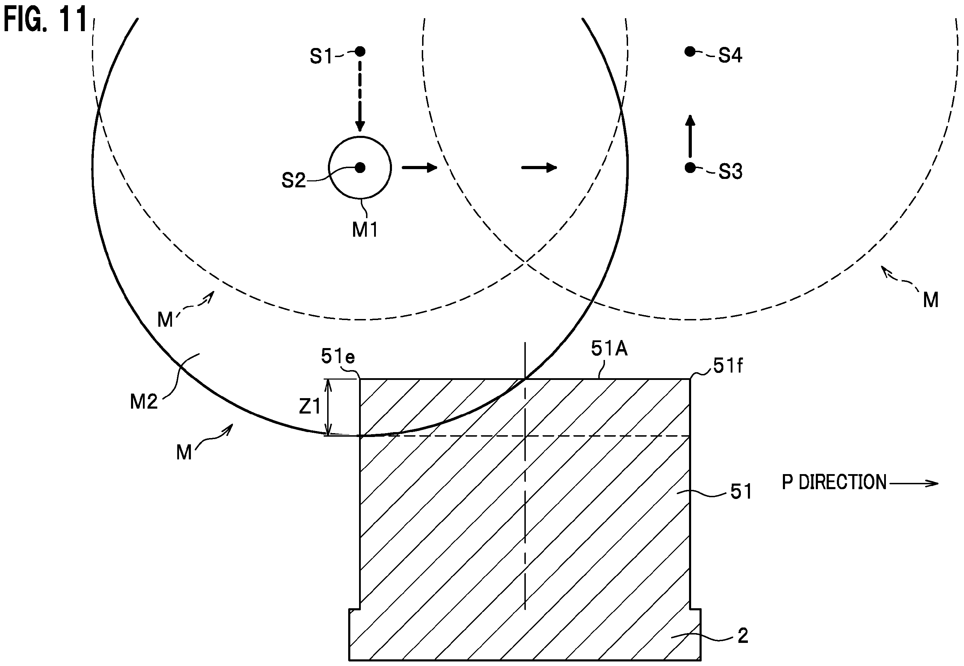

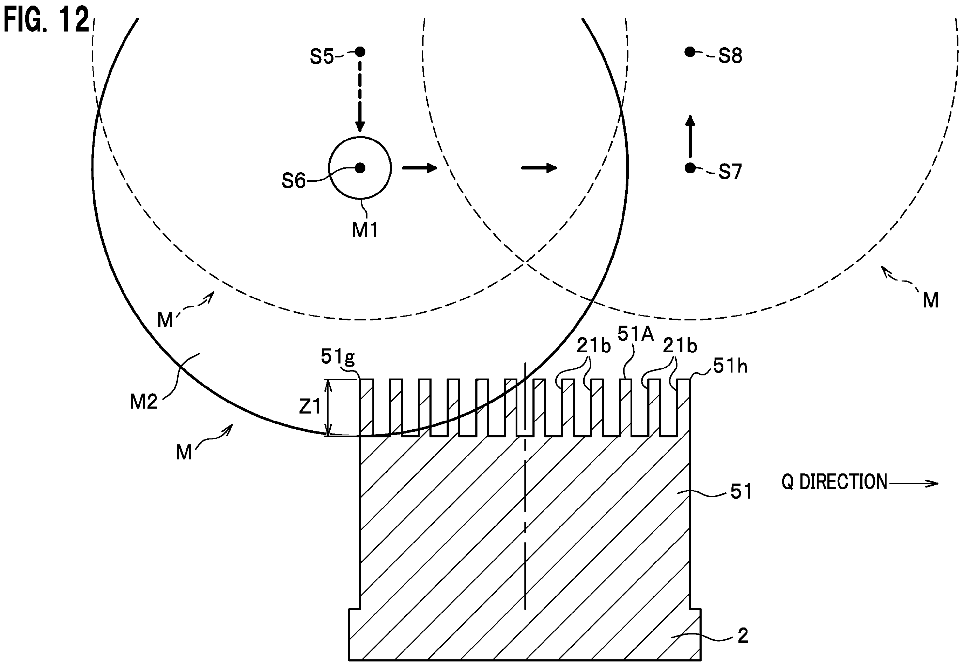

As shown in FIGs. 11 and 12, the first-stage processing step forms the first-slit upper portions 21b and the second-slit upper portions 22b by using the multi-cutter M to form the pin-fin upper portions 11. The first-stage processing step includes a first step and a second step. The first step and the second step have a relationship in which after a plurality of slits are formed in the first step, a plurality of slits intersecting the plurality of slits formed in the first step are formed in the second step.

In the first step, as shown in FIG. 11, the multi-cutter M is inserted into the block portion (the workpiece block) 51 from an imaginary point S1 set directly above the apex 51e to have a specified depth Z1 and cuts distal end portions of the block portion (the workpiece block) 51. The imaginary point S1, an imaginary point S2, an imaginary point S3, and an imaginary point S4 are positions that the axis of the shaft M1 of the multi-cutter M passes through. The imaginary points S1 and S2 are set directly above the apex 51e. The imaginary points S3 and S4 are set directly above the apex 51f. The distance from the apex 51e to the imaginary point S2 and the distance from the apex 51f to the imaginary point S3 are equal. Note that regarding the relationships between the depth Z1 and depths Z2 and Z3 described later, Z1 is the smallest, Z2 and Z3 are greater than Z1, and Z3 is greater than Z1 and Z2.

In the first step, first, the axis of the shaft M1 of the multi-cutter M is positioned at the imaginary point S1. Then, the multi-cutter M is moved vertically downward, and the axis of the shaft M1 is positioned at the imaginary point S2. With this process, the disc cutters M2 are inserted to the position at the specified depth Z1 from the apex 51e. The specified depth Z1 is equal to the height dimension of the pin-fin upper portion 11. Next, the shaft M1 of the multi-cutter M is moved parallel to the end surface 51A, in other words, with the specified depth Z1 kept, to the imaginary point S3. When the axis of the shaft M1 reaches the imaginary point S3, the multi-cutter M is pulled straight up and moved to the imaginary point S4. With this process, the plurality of first-slit upper portions 21b parallel to the P direction are formed.

In the second step, as shown in FIG. 12, the multi-cutter M is inserted into the block portion (the workpiece block) 51 from an imaginary point S5 set directly above the apex 51g to have the specified depth Z1 and cuts distal end portions of the block portion (the workpiece block) 51. The imaginary point S5, an imaginary point S6, an imaginary point S7 and an imaginary point S8 are positions that the axis of the shaft M1 of the multi-cutter M passes through. The imaginary points S5 and S6 are set directly above the apex 51g. The imaginary points S7 and S8 are set directly above the apex 51h. The distance from the apex 51g to the imaginary point S6 and the distance from the apex 51h to the imaginary point S7 are equal.

In the second step, first, the axis of the shaft M1 of the multi-cutter M is positioned at the imaginary point S5. Then, the multi-cutter M is moved vertically downward, and the axis of the shaft M1 is positioned at the imaginary point S6. With this process, the disc cutters M2 are inserted to the position at the specified depth Z1 from the apex 51g. The specified depth Z1 is equal to the height dimension of the pin-fin upper portion 11. In other words, the specified depth Z1 is equal to that in the first step. Next, the shaft M1 of the multi-cutter M is moved parallel to the end surface 51A, in other words, with the specified depth Z1 kept, to the imaginary point S7. When the axis of the shaft M1 reaches the imaginary point S7, the multi-cutter M is pulled straight up and moved to the imaginary point S8. With this process, the plurality of second-slit upper portions 22b parallel to the Q direction are formed, and thereby the plurality of pin-fin upper portions 11 are formed.

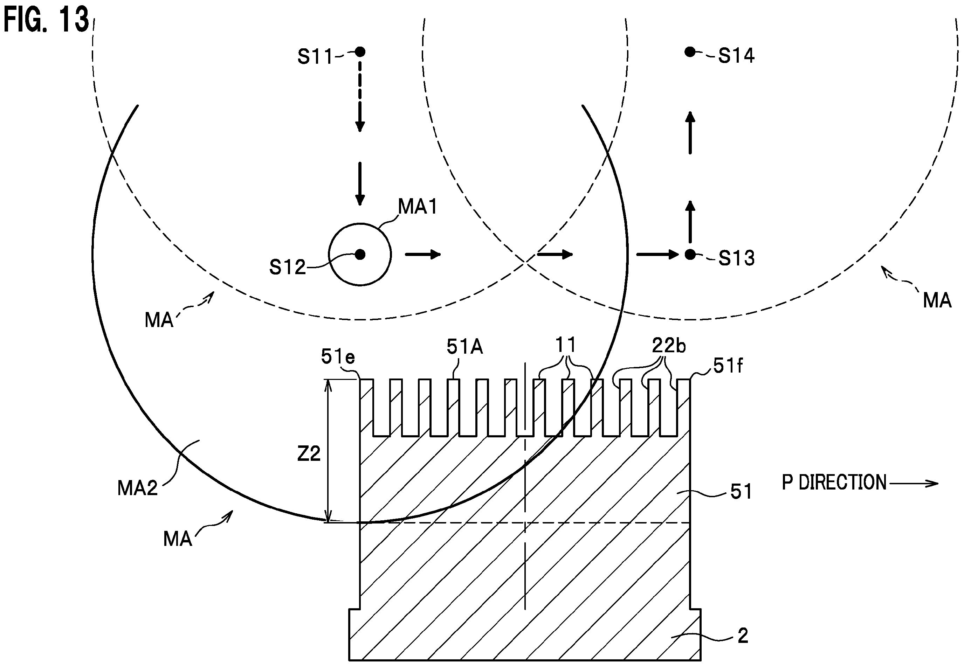

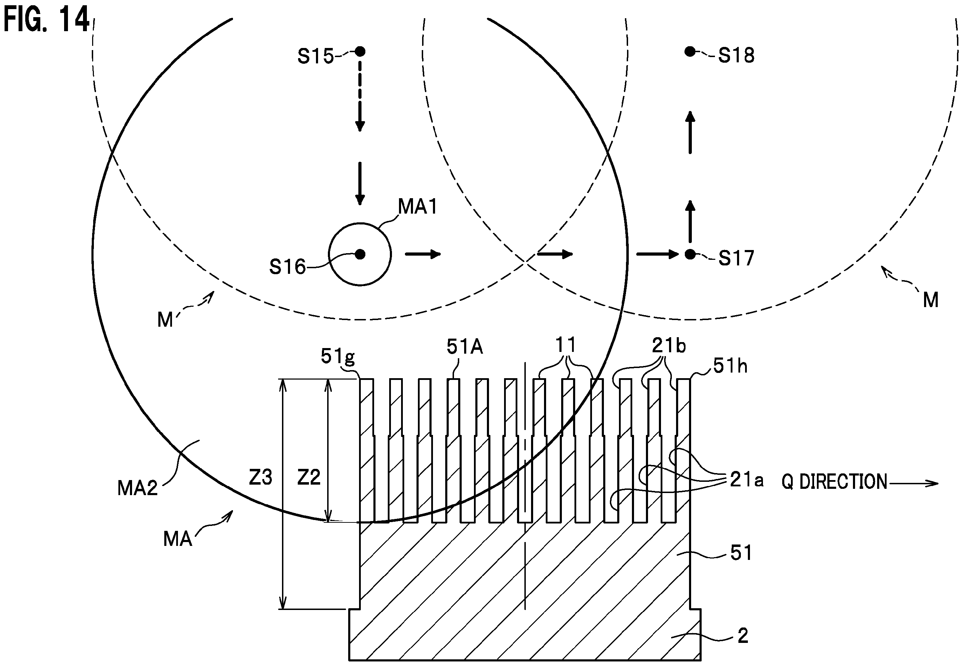

As shown in FIGs. 13 and 14, the second-stage processing step forms the first-slit lower portions 21a and the second-slit lower portions 22a by using a multi-cutter MA to form the pin-fin lower portions 10. The multi-cutter MA includes a shaft MA1 and a plurality of disc cutters MA2 layered at intervals. The thickness KA (not illustrated) of the disc cutter MA2 is less than the thickness K of the disc cutter M2. More specifically, in the multi-cutter MA, the attachment positions of the disc cutters MA2 are the same as those of the disc cutters M2 of the multi-cutter M, and only the thickness KA of the disc cutter MA2 is different and thinner. In the present embodiment, the thickness KA of the disc cutter MA2 is equal to the slit width W1 of the first-slit lower portion 21a and the slit width W3 of the second-slit lower portion 22a.

The second-stage processing step includes an upper-portion step and a lower-portion step. Specifically, in the second-stage processing step, cutting is performed in two steps with different specified depths (insertion depths) from the end surface 51A. The upper-portion step includes a first step and a second step.

In the first step of the upper-portion step, as shown in FIG. 13, the multi-cutter MA is inserted into the block portion (the workpiece block) 51 from an imaginary point S11 set directly above the apex 51e to have the specified depth Z2 and cuts middle portions of the block portion (the workpiece block) 51. The imaginary point S11, an imaginary point S12, an imaginary point S13, and an imaginary point S14 are positions that the axis of the shaft MA1 of the multi-cutter MA passes through. The imaginary points S11 and S12 are set directly above the apex 51e. The imaginary points S13 and S14 are set directly above the apex 51f. The distance from the apex 51e to the imaginary point S12 and the distance from the apex 51f to the imaginary point S13 are equal.

In the first step of the upper-portion step, first, the axis of the shaft MA1 of the multi-cutter MA is positioned at the imaginary point S11. Then, the multi-cutter MA is moved vertically downward, and the axis of the shaft MA1 is positioned at the imaginary point S12. With this process, the disc cutters MA2 are inserted to the position at the specified depth Z2 from the apex 51e. The specified depth Z2 is equal to the sum of the height dimension of the pin-fin upper portion 11 and half of the height dimension of the pin-fin lower portion 10. Next, the shaft MA1 of the multi-cutter MA is moved parallel to the end surface 51A, in other words, with the specified depth Z2 kept, to the imaginary point S13. When the shaft MA1 reaches the imaginary point S13, the multi-cutter MA is pulled straight up and moved to the imaginary point S14. With this process, upper portions of the plurality of first-slit lower portions 21a parallel to the P direction are formed.

In the second step of the upper-portion step, as shown in FIG. 14, the multi-cutter MA is inserted into the block portion (the workpiece block) 51 from an imaginary point S15 set directly above the apex 51g to have the specified depth Z2 and cuts middle portions of the block portion (the workpiece block) 51. The imaginary point S15, an imaginary point S16, an imaginary point S17, and an imaginary point S18 are positions that the axis of the shaft MA1 of the multi-cutter MA passes through. The imaginary points S15 and S16 are set directly above the apex 51g. The imaginary points S17 and S18 are set directly above the apex 51h. The distance from the apex 51g to the imaginary point S16 and the distance from the apex 51h to the imaginary point S17 are equal.

In the second step of the upper-portion step, first, the axis of the shaft MA1 of the multi-cutter MA is positioned at the imaginary point S15. Then, the multi-cutter MA is moved vertically downward, and the axis of the shaft MA1 is positioned at the imaginary point S16. With this process, the disc cutters MA2 are inserted to the position at the specified depth Z2 from the apex 51g. The specified depth Z2 is equal to the sum of the height dimension of the pin-fin upper portion 11 and half of the height dimension of the pin-fin lower portion 10. In other words, the specified depth Z2 is equal to that in the first step of the upper-portion step. Next, the shaft MA1 of the multi-cutter MA is moved parallel to the end surface 51A, in other words, with the specified depth Z2 kept, to the imaginary point S17. When the axis of the shaft MA1 reaches the imaginary point S17, the multi-cutter MA is pulled straight up and moved to the imaginary point S18. With this process, upper portions of the plurality of second-slit lower portions 22a parallel to the Q direction are formed.

Although specific illustration is omitted, the lower-portion step includes a first step and a second step using the multi-cutter MA. The first step of the lower-portion step is the same as the first step of the upper-portion step except the insertion depth (specified depth). The second step of the lower-portion step is the same as the second step of the upper-portion step except the insertion depth (specified depth). As shown in FIG. 14, the specified depth Z3 in the lower-portion step is equal to the total length of the pin fin 3. With this process, the lower portions of the plurality of first-slit lower portions 21a and the lower portions of the plurality of second-slit lower portions 22a are formed. Thus, the plurality of pin-fin lower portions 10 are formed, and thereby the heat sink 1 is formed.

In the heat sink 1 and the heat sink production method according to the first embodiment described above, the slit widths W2 and W4 of the first slit 21 and the second slit 22 corresponding to the pin-fin upper portion 11 are greater than the slit widths W1 and W3 of the first slit 21 and the second slit 22 corresponding to the pin-fin lower portion 10. This configuration prevents the disc cutters MA2 of the multi-cutter MA from coming into contact with the pin fins 3 under formation in the second-stage processing step. Accordingly, this configuration makes it easy to form taller pin fins 3 while increasing the formation accuracy.

As in the present embodiment, it is preferable that the pin-fin lower portion 10 and the pin-fin upper portion 11 form a stepped shape in side view, and the fin width XC (XD) of the pin-fin upper portion 11 be less than the fin width XA (XB) of the pin-fin lower portion 10. Note that the "side view" in this specification denotes viewing in a direction orthogonal to the height direction (axis direction) of the pin fins 3 standing on the base 2. For example, by using the multi-cutters M and MA including the disc cutters M2 and MA2 having different thicknesses as in the present embodiment, it is easy to make a step between the pin-fin lower portion 10 and the pin-fin upper portion 11.

In addition, since the shape of the pin-fin lower portion 10 and the shape of the pin-fin upper portion 11 are similar in the present embodiment, it is possible to reduce unevenness in the flow of fluid such as a liquid and a gas. In addition, since the axis G1 (axial center) of the pin-fin lower portion 10 is aligned with the axis G2 (axial center) the pin-fin upper portion 11, it is possible to further reduce unevenness in the flow of fluid.

It is preferable that the difference between the fin width XA (XB) of the pin-fin lower portion 10 and the fin width XC (XD) of the pin-fin upper portion 11 be 0.1 mm or more. In addition, it is preferable that the dimensions YA and YB of the steps between the pin-fin lower portion 10 and the pin-fin upper portion 11 be 0.05 mm or more. It is also preferable that the difference between the fin width XA (XB) of the pin-fin lower portion 10 and the fin width XC (XD) of the pin-fin upper portion 11 be 1% or more of the fin width XA (XB) of the pin-fin lower portion 10. Such a configuration makes it possible to prevent the disc cutters M2 and MA2 from coming into contact with the pin fins 3 under formation and also possible to prevent a decrease in the heat exchange efficiency by making the difference between the fin widths of the pin-fin lower portion 10 and the pin-fin upper portion 11 as little as possible.

It is preferable that the slit width W1 (W3) be 0.5 to 10 times the fin width XA (XB) of the pin fin 3. It is also preferable that the height dimension of the pin fin 3 be 1 to 300 mm.

Here, in some cases, irregular pin fins can be formed on the edges of the base 2 after the first-stage processing step and the second-stage processing step are performed. If irregular pin fins are formed, the irregular pin fins are likely to come into contact with the multi-cutters M and MA, which can cause deformation and damage to other pin fins 3 and the disc cutters M2 and MA2. In this respect, the cut-off step is performed in the present embodiment to remove peripheral edge portions of the workpiece block 50 in advance. Since this process prevents irregular fins from being formed on the edges of the base 2, it is possible to prevent deformation and damage to the pin fins 3 and the disc cutters M2 and MA2. Since wavy processing or zigzag processing is performed in the cut-off step, the portions of the workpiece block 50 where regular pin fins are to be formed remain, and the portions where irregular pin fins are to be formed are removed so that irregular pin fins will not be formed.

Here, if the cutting depth (the depth in which the block portion is actually cut) of the multi-cutters M and MA is large, the cutting resistance is also large. This would cause a problem that the disc cutters M2 and MA2 are more likely to shake (vibrate) in the thickness direction, which makes it more likely for the disc cutters M2 and MA2 to come into contact with the pin fin 3 under formation.

In the case in which the cutting depth (the specified depth Z3 - the specified depth Z1 (see FIG. 14)) is large as in the second-stage processing step, the cutting resistance is large if the processing is performed in a single step. In this respect, the cutting process is divided into two or more steps, each with a smaller insertion depth, in the present embodiment. This prevents the disc cutter MA2 from coming into contact with the pin fins 3 under formation, thereby increasing the formation accuracy.

However, for example, in the case in which the insertion depth (specified depth Z1) is small as in the first-stage processing step of the present embodiment, the processing may be completed in a single step. Because the cutting resistance is small in the first-stage processing step, the processing is completed in a single step to increase the work efficiency.

Note that the insertion depth for cutting in the first-stage processing step may be divided into two or more steps, and the second-stage processing step may be completed in a single cutting step.

It is preferable that after the plurality of intersecting slits, in other words, the first-slit upper portions 21b and the second-slit upper portions 22b, are formed in the first-stage processing step, the plurality of intersecting slits, in other words, the first-slit lower portions 21a and the second-slit lower portions 22a, be formed in the second-stage processing step. This process reduces the number of exchanges between the multi-cutter M and the multi-cutter MA and thereby increases the work efficiency.

### [2. Second Embodiment]

Next, a heat sink production method according to a second embodiment of the present invention will be described. In the first-stage processing step and the second-stage processing step described above, cutting is performed in a single pass. The second embodiment differs from the first embodiment in that each of the first-stage processing step and the second-stage processing step is performed in two passes. The present embodiment is described with an emphasis on the points different from the first embodiment.

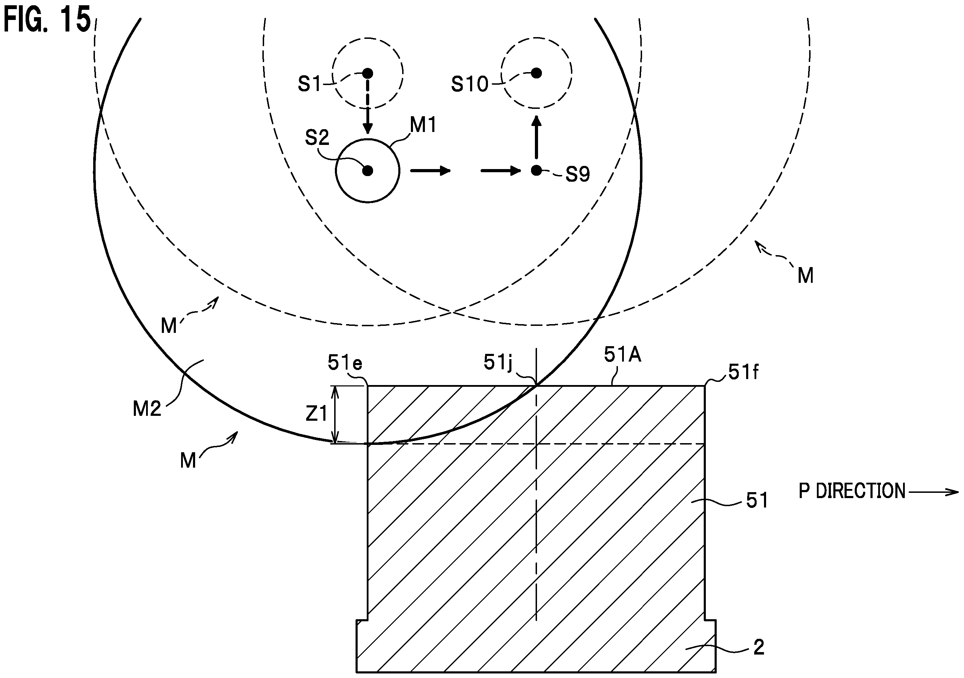

In a first step of the first-stage processing step according to the second embodiment, as shown in FIG. 15, the multi-cutter M is inserted from the imaginary point S1 set directly above the apex 51e to have the specified depth Z1 to cut distal end portions of the block portion (the workpiece block) 51. The imaginary point S1, the imaginary point S2, an imaginary point S9, and an imaginary point S10 are positions that the axis of the shaft M1 of the multi-cutter M passes through. The imaginary points S1 and S2 are set directly above the apex 51e. The imaginary points S3 and S4 are set directly above the apex 51f. The imaginary points S9 and S10 are set directly above the center 51j (see also FIG. 9) of the block portion 51. The distance from the apex 51e to the imaginary point S2 and the distance from the center 51j to the imaginary point S9 are equal.

In the first step, first, for a first pass, the axis of the shaft M1 of the multi-cutter M is positioned at the imaginary point S1. Then, the multi-cutter M is moved vertically downward, and the axis of the shaft M1 is positioned at the imaginary point S2. With this process, the disc cutters M2 are inserted to the position at the specified depth Z1 from the apex 51e. The specified depth Z1 is equal to the height dimension of the pin-fin upper portion 11. Next, the shaft M1 of the multi-cutter M is moved parallel to the end surface 51A, in other words, with the specified depth Z1 kept, to the imaginary point S9. When the axis of the shaft M1 reaches the imaginary point S9, the multi-cutter M is pulled straight up and moved to the imaginary point S10. Note that when the multi-cutter M is pulled up at the position of the imaginary point S9, the rotation of the multi-cutter M is stopped upon reaching the imaginary point S9, and the multi-cutter M is pulled up with its rotation stopped.

Next, in the first step of the first-stage processing step according to the second embodiment, for a second pass, the axis of the shaft M1 of the multi-cutter M is positioned at the imaginary point S4. Then, the multi-cutter M is moved vertically downward, and the axis of the shaft M1 is positioned at the imaginary point S3. With this process, the disc cutters M2 are inserted to the position at the specified depth Z1 from the apex 51f. The specified depth Z1 is equal to the height dimension of the pin-fin upper portion 11. Next, the shaft M1 of the multi-cutter M is moved parallel to the end surface 51A, in other words, with the specified depth Z1 kept, to the imaginary point S9. When the axis of the shaft M1 reaches the imaginary point S9, the multi-cutter M is pulled straight up and moved to the imaginary point S10. With this process, the plurality of first-slit upper portions 21b parallel to the P direction are formed.

As in the heat sink production method according to the second embodiment described above, when the first-stage processing step and the second-stage processing step are performed, the multi-cutter M (the multi-cutter MA) may be once moved away from the block portion 51 in the course of processing the block portion 51, and it may be inserted again to perform cutting in two or more steps (two or more passes). In particular, in the case in which the cutting length is long, this process makes it possible to increase the formation accuracy.

Although the insertion positions are at the apex 51e and the apex 51f in the present embodiment, the multi-cutter M (the multi-cutter MA) may be inserted from the center 51j and moved away at the apex 51e and the apex 51f. Also in the second-stage processing step, cutting may be performed in two or more passes as in the present embodiment.

The heat sink production method according to the second embodiment makes it more likely to prevent the disc cutters MA2 of the multi-cutter MA from coming into contact with the pin fins 3 under formation in the second-stage processing step.

### [3. Third Embodiment]

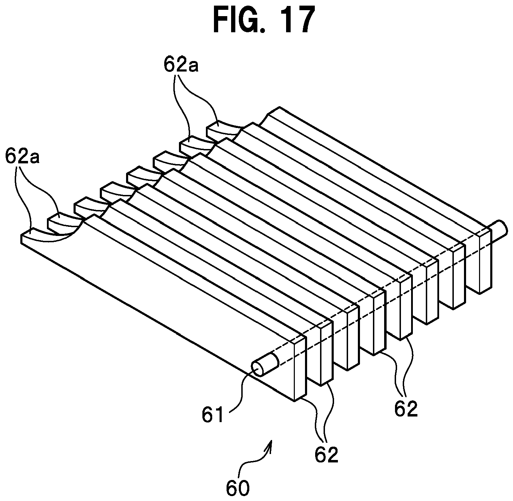

Next, a heat sink production method according to a third embodiment of the present invention will be described. FIG. 17 is a perspective view of an insertion jig 60 used in the heat sink production method according to the third embodiment. As shown in FIG. 17, the insertion jig 60 includes a connection shaft 61 and a plurality of insertion members 62. The insertion jig 60 is used for forming the first slits 21 or the second slits 22. The insertion jig 60 is inserted into the slits between the pin fins 3, 3 under formation, formed in the block portion (the workpiece block) 51, and cutting of the block portion (the workpiece block) 51 is performed in this state.

The connection shaft 61 is a rod-shaped member passing through one end side of each insertion member 62. Each insertion member 62 is a plate-shaped member. The thickness of the insertion member 62 should preferably be a dimension that enables the insertion member 62 to be inserted into a slit between adjacent pin fins 3, 3 under formation without a gap. The gap between adjacent insertion members 62, 62 is set to be equal to the fin width XA (XB) of the pin-fin lower portion 10. Each insertion member 62 has the other end side having an arc-shaped cut portion 62a. The thickness of the insertion member 62 may be changed as appropriate in accordance with the size of the slit. The gap dimension of the insertion members 62, 62 may be changed as appropriate in accordance with the fin width XA (XB) of the pin fin 3.

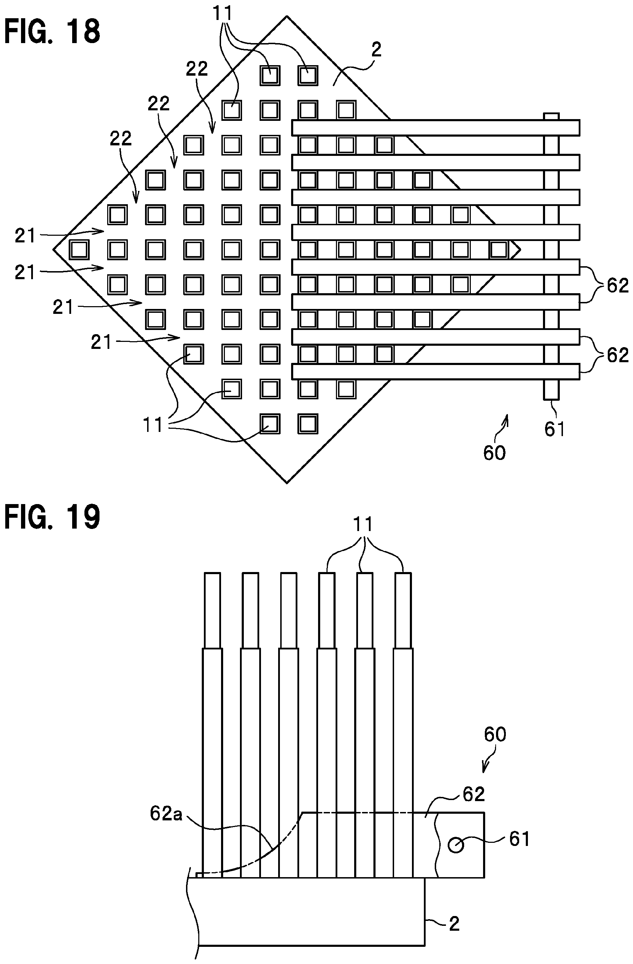

As shown in FIGs. 18 and 19, for example, when the second-stage processing step is performed in two passes, in the second pass of the first step of the lower-portion step, the insertion jig 60 may be inserted between the pin fins 3, 3 under formation, in other words, at the positions of the first-slit lower portions 21a under cutting, formed in the first pass. With this process, a proximal-end portion of each pin fin 3 under formation is supported by the corresponding adjacent insertion members 62, 62, and thus it is possible to prevent distal end portions of the pin fins 3 under formation from shaking (vibrating) in the width direction when cutting is performed. This process prevents the pin fins 3 under formation from coming into contact with the disc cutter M2 or MA2 and thus increases the formation accuracy. In addition, since the cut portion 62a is formed in the other end side of the insertion member 62, it is possible to prevent the insertion members 62 from coming into contact with the multi-cutter M or MA.

Note that the length and the height of the insertion member 62 may be changed as appropriate in accordance with the cutting modes of the first-stage processing step and the second-stage processing step.

### [4. First Modification Example]

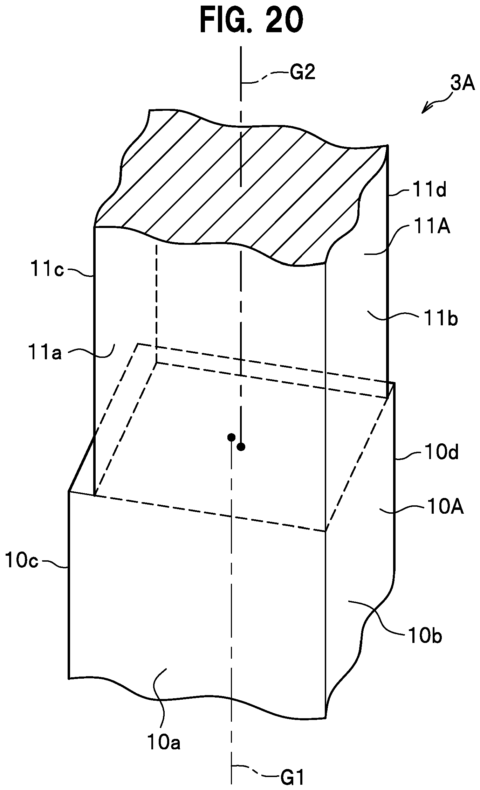

FIG. 20 is a perspective view of a pin fin according to a first modification example. As shown in FIG. 20, a pin fin 3A according to the first modification example differs from that in the embodiments described above in that the axes G1 and G2 are shifted from each other.

Adjoining side surfaces 10a and 10b of the pin-fin lower portion 10 of the pin fin 3A are flush, respectively, with adjoining side surfaces 11a and 11b of the pin-fin upper portion 11 located above the side surfaces 10a and 10b, respectively. In contrast, there are steps between adjoining side surfaces 10c and 10d of the pin-fin lower portion 10 of the pin fin 3A and adjoining side surfaces 11c and 11d of the pin-fin upper portion 11 located above the side surfaces 10c and 10d, respectively. Hence, the axis (axial center) G1 of the pin-fin lower portion 10 and the axis (axial center) G2 of the pin-fin upper portion 11 are shifted from each other.

### [5. Second Modification Example]

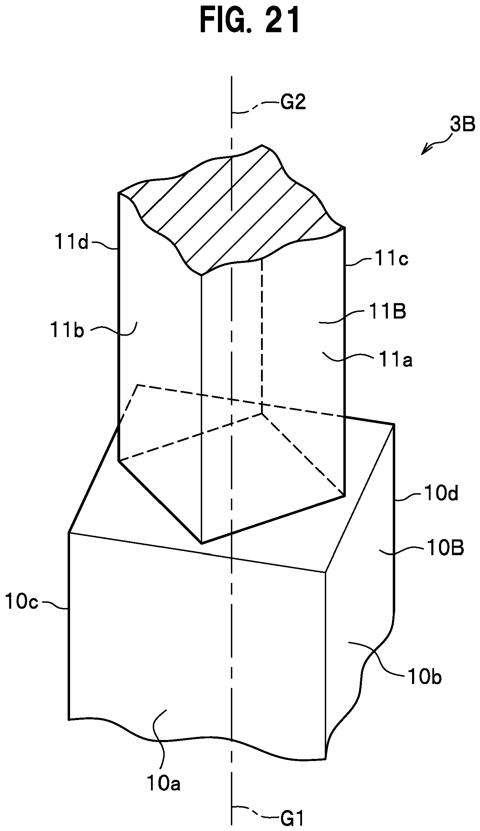

FIG. 21 is a perspective view of a pin fin according to a second modification example. As shown in FIG. 21, a pin fin 3B according to the second modification example differs from that in the embodiments described above in that the orientation of the pin-fin upper portion 11 differs from that of the pin-fin lower portion 10. Specifically, the pin-fin upper portion 11 is oriented at a 45-degree angle around the axis G2 in relation to the pin-fin lower portion 10. The axis (axial center) G1 of the pin-fin lower portion 10 is aligned with the axis (axial center) G2 of the pin-fin upper portion 11.

### [6. Others]

As in the first modification example and the second modification example, the positional relationship between the pin-fin lower portion 10 and the pin-fin upper portion 11, the shapes and the fin widths of these, the length of the pin-fin upper portion 11, and the like may be determined as appropriate in accordance with the type of fluid that flows and the application of the heat sink.

For example, the first modification example enables fluid to flow, being biased on purpose. The second modification example enables the flow of fluid to differ between in the periphery of the pin-fin lower portion 10 and in the periphery of the pin-fin upper portion 11. The shapes of the pin-fin lower portion 10 and the pin-fin upper portion 11 are not limited to being similar and may be different. The pin fin 3 may have a shape in which the cross-sectional area decreases (the fin width decreases) from the proximal end side toward the distal end side.

For example, the shape of the pin fin 3 may be a triangular prism. In this case, a plurality of first slits, a plurality of second slits, and a plurality of third slits intersecting one another are formed. The cross section of the pin fin 3 may be a rhombus, a parallelogram, or a rectangle. Although the multi-cutters M and MA are moved for cutting along a diagonal line of the block portion 51 in the present embodiment, the shafts M1 and MA1 of the multi-cutters M and MA, for example, may be set parallel to the side 51a to perform cutting. Although the multi-cutters M and MA are inserted into the end surface 51A perpendicularly to the end surface 51A in the present embodiment, the insertion direction may be oblique. It is preferable that the pin fins 3 may be arranged in a houndstooth patten relative to the direction in which a refrigerant flows.

The embodiments and the modification examples described above are based on the examples in which the plurality of first slits 21 are formed to be straight and parallel to one another, and the plurality of second slits 22 are formed to be straight and parallel to one another. However, the plurality of first slits 21 are not limited to a configuration in which the slits are straight, and adjacent slits are parallel, and the plurality of second slits 22 are not limited to a configuration in which the slits are straight, and adjacent slits are parallel. For example, a plurality of first slits 21 or a plurality of second slits 22 may have a configuration in which two kinds of two or more straight slits having different angles are alternately arranged on the heat sink 1 so as not to intersect one another. Alternatively, a plurality of first slits 21 or a plurality of second slits 22 may have a configuration in which a plurality of slits are arranged to extend in a sector shape without intersecting one another on the heat sink 1.

The embodiments and the modification examples described above are based on the examples in which the thickness K of the disc cutter M2 used in the first-stage processing step is greater than the thickness KA of the disc cutter MA2 used in the second-stage processing step so that the slit width W2 of the first-slit upper portion 21b and the slit width W4 of the second-slit upper portion 22b are greater than the slit width W1 of the first-slit lower portion 21a and the slit width W3 of the second-slit lower portion 22a. However, instead of the disc cutters M2 and the multi-cutter M used in the first-stage processing step, the disc cutters MA2 and the multi-cutter MA used in the second-stage processing step may be used. In this case, in the first step of the first-stage processing step, the multi-cutter MA is moved as the first cutting step from the imaginary point S1 via the imaginary point S2 and the imaginary point S3 to the imaginary point S4 to form slits having widths equal to the thickness KA. Next, as the second cutting step, the multi-cutter MA is similarly moved from the imaginary point S1 via the imaginary point S2 and the imaginary point S3 to the imaginary point S4 at the position shifted in parallel by the distance corresponding to the difference between the slit width W2 of the first-slit upper portion 21b and the thickness KA in the Q direction from the position of the first cutting step. With these process, the first-slit upper portions 21b having a slit width W2 equal to the thickness K are formed. Next, by also performing the second step of the first-stage processing step as in the first step, slits of the second-slit upper portions 22b having a slit width W4 equal to the thickness K are formed. As described above, by using (using continuously) the disc cutters and the multi-cutter having the same thickness in both the first-stage processing step and the second-stage processing step, it is possible to eliminate the inconvenience of replacing the multi-cutters and thereby improve the work efficiency.

The embodiments and the modification examples described above are based on the examples in which after the first-stage processing step including the first step and the second step is performed, the second-stage processing step including the first step and the second step is performed. However, the order of forming the first-slit upper portions 21b, the second-slit upper portions 22b, the first-slit lower portions 21a, and the second-slit lower portions 22a may be changed as appropriate. For example, after the first step of the first-stage processing step is performed to form the first-slit upper portions 21b, the first step of the second-stage processing step may be performed to form the first-slit lower portions 21a. Then, after the second step of the first-stage processing step is performed to form the second-slit upper portions 22b, the second step of the second-stage processing step may be performed to form the second-slit lower portions 22a.

The embodiments and the modification examples described above are based on the examples in which the multi-cutters M and MA including the disc cutters M2 and M2A are used to cut the workpiece block 50 and form the first-slit upper portions 21b and the second-slit upper portions 22b, and the pin-fin upper portions 11 and the pin-fin lower portions 10. However, cutting of the workpiece block 50 is not limited to the way described above and may be changed as appropriate. For example, a single disc cutter M2 may be used alone for cutting. For example, a publicly known cutting method such as a wire saw, an end mill, laser processing, or electrical discharge machining may be used. Also for such cutting methods, application of the present invention prevents a cutting tool from coming into contact with the pin fins 3 under formation when the second-stage processing step is performed, thereby making it possible to achieve high formation accuracy and easily form taller pin fins.

In the first-stage processing step and the second-stage processing step, at least one of the multi-cutter M or MA and the workpiece block 50 is moved for cutting.

Cutting of the first-stage processing step and the second-stage processing step may be performed in three or more stages. Specifically, slits may be formed to have three or more different slit widths that increase stepwise from the bottom toward the top, so that pin fins having three or more different widths that decrease stepwise from the bottom toward the top are formed. In this case, the relationship between the N-th tier and the (N-1)-th tier is set to satisfy the relationship between the second-stage processing step and the first-stage processing step.

In the heat sink production method for the present invention, a cutting step of cutting the end surface (upper surface) 51A of the block portion 51 may be performed before performing the first-stage processing step and the second-stage processing step. The cutting step may be performed before or after the cut-off step or may be performed simultaneously with the cut-off step. For example, an end mill can be used for the cutting. The cutting step may be performed at any position on the end surface 51A of the block portion 51. In the end surface 51A of the block portion 51, in particular, it is preferable to cut areas including positions at which the pin fins 3 are to be formed in the first-stage processing step and the second-stage processing step. More specifically, it is preferable that portions including the end surface 51A of the block portion 51 in the areas not subjected to cutting by the multi-cutter M, thus where the first slits 21 and the second slits 22 are not to be formed, are cut in advance. With this process, it is possible to reduce the height of the pin fins 3 formed after the first-stage processing step and the second-stage processing step in accordance with the depth cut in the cutting step at the desired positions cut in the cutting step. In addition, if cutting is performed only for part of the positions at which the pin fins 3 are to be formed, and cutting is not performed at the other positions at which the pin fins 3 are to be formed, it is possible to provide a heat sink 1 with pin fins 3 having different heights.

### [7. Evaluation Test]

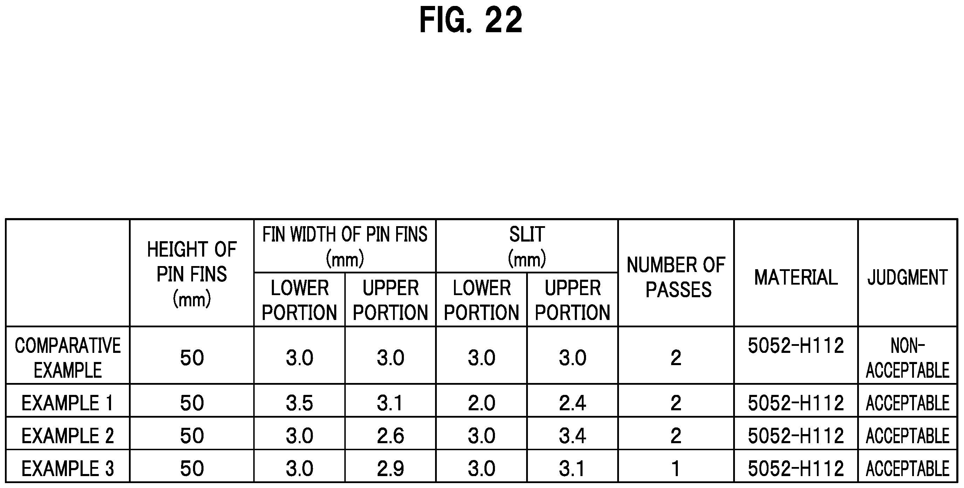

Next, an evaluation test of the present invention will be described. As shown in FIG. 22, in the evaluation test, heat sinks according to Comparative Example 1 and Examples 1 to 3 were produced, and the state of the pin fins of each formed heat sink was evaluated. If produced pin fins included no or very few missing fins or broken fins, the heat sink was rated as "acceptable", and if there were many missing fins or broken fins, the heat sink was rated as "non-acceptable". The conditions for Comparative Example 1 and Example 1 to 3 are as shown in FIG. 22.

In Comparative Example 1 and Example 1 to 3, the height of the pin fins is 50 mm, the processing step for cutting was divided into four steps, each with a cutting depth of 12.5 mm in the height direction. In the number of passes, "one pass" indicates a mode the same as or similar to that in the first embodiment, and "two passes" indicates a mode the same as or similar to that in the second embodiment. The material of each workpiece block was an aluminum alloy JIS A5052-H112. The number of revolutions of a multi-cutter was 2000 rpm, and the moving speed was 800 mm/min. The cross-sectional shape of the pin fin is a rhombus (square).

The fin width of the pin fin of Comparative Example 1 is constant regardless of the height and is 3.0 mm. The width of the slit (the first slit and the second slit) is constant regardless of the height and is 3.0 mm. Comparative Example 1 was processed in two passes.

In Example 1, the fin width of the pin-fin lower portion is 3.5 mm, and the fin width of the pin-fin upper portion is 3.1 mm. In Example 1, the slit width of the slit lower portion is 2.0 mm, and the slit width of the slit upper portion is 2.4 mm. Example 1 was processed in two passes.

In Example 2, the fin width of the pin-fin lower portion is 3.0 mm, and the fin width of the pin-fin upper portion is 2.6 mm. In Example 2, the slit width of the slit lower portion is 3.0 mm, and the slit width of the slit upper portion is 3.4 mm. Example 2 was processed in two passes.

In Example 3, the fin width of the pin-fin lower portion is 3.0 mm, and the fin width of the pin-fin upper portion is 2.9 mm. In Example 3, the slit width of the slit lower portion is 3.0 mm, and the slit width of the slit upper portion is 3.1 mm. Example 3 was processed in one pass.

In Comparative Example 1, the upper ends of many pin fins were missing, and accordingly Comparative Example 1 was rated "non-acceptable". Comparative Example 1 had many missing fins in the fourth tier. Specifically, when cutting is performed at a position deep from the end surface (upper surface) of a block portion, the disc cutters are likely to come into contact with pin fins under formation, leading to missing or broken fins.

In contrast, Example 1 to 3 did not have missing or broken pin fins, and accordingly they were rated as "acceptable". In all of Example 1 to 3, the slit width is greater in the slit upper portions than in the slit lower portions. This configuration makes it possible to prevent disc cutters from coming into contact with pin fins under formation, and hence, cutting can be performed in a deeper position. Even a configuration in which the step between the pin-fin lower portion and the pin-fin upper portion is 0.1 mm as in Example 3 provided a acceptable result. In Example 1 to 3, both one-pass processing and two-pass processing provided acceptable results.

### Reference Signs List

- 1: heat sink
- 2: base
- 3: pin fin
- 10: pin-fin lower portion
- 11: pin-fin upper portion
- 21: first slit (slit)
- 21a: first-slit lower portion
- 21b: first-slit upper portion
- 22: second slit (slit)
- 22a: second-slit lower portion
- 22b: second-slit upper portion
- M: multi-cutter
- M1: shaft
- M2: disc cutter
- MA: multi-cutter
- MA1: shaft
- MA2: disc cutter
- XA, XB, XC, XD: fin width
- W1, W2, W3, W4: slit width

## Claims

1. A heat sink comprising:
a plate-shaped base;
a plurality of pin fins separately standing on the base; and
a plurality of slits located between the plurality of pin fins to separate the plurality of pin fins, wherein
the slits includes
a plurality of first slits arranged to be straight on the base and
a plurality of second slits arranged to be straight on the base and intersecting the first slits,
each pin fin includes a pin-fin lower portion being continuous with and standing on the base and a pin-fin upper portion being continuous with and extending from the pin-fin lower portion, and
slit widths of the first slits and the second slits, the slit widths corresponding to the pin-fin upper portions, are greater than slit widths of the first slits and the second slits, the slit widths corresponding to the pin-fin lower portion.

2. The heat sink according to claim 1, wherein
the pin-fin lower portion and the pin-fin upper portion form a stepped shape in side view, and
a fin width of the pin-fin upper portion is less than a fin width of the pin-fin lower portion.

3. The heat sink according to claim 1, wherein
a cross section of the pin-fin lower portion and a cross section of the pin-fin upper portion have similar shapes.

4. The heat sink according to claim 1, wherein
an axial center of the pin-fin lower portion is aligned with an axial center of the pin-fin upper portion.

5. The heat sink according to claim 1, wherein
an axial center of the pin-fin lower portion and an axial center of the pin-fin upper portion are shifted from each other.

6. The heat sink according to claim 1, wherein
a difference between a fin width of the pin-fin lower portion and a fin width of the pin-fin upper portion is o.1 mm or more.

7. The heat sink according to claim 1, wherein
a dimension of a step between the pin-fin lower portion and the pin-fin upper portion is 0.05 mm or more.

8. The heat sink according to claim 1, wherein
a difference between a fin width of the pin-fin lower portion and a fin width of the pin-fin upper portion is 1% or more of the fin width of the pin-fin lower portion.

9. The heat sink according to claim 1, wherein
a fin width of each pin fin is 2 to 20 mm.

10. The heat sink according to claim 1, wherein
a width of each slit is 0.5 to 10 times a fin width of the pin fin.

11. The heat sink according to claim 1, wherein
a height dimension of each pin fin is 1 to 300 mm.

12. A method for producing a heat sink including a plurality of pin fins, comprising:
a first-stage processing step of cutting a workpiece block from an end surface of the workpiece block to a position at a specified depth to form a plurality of intersecting slits; and
a second-stage processing step of cutting, after the first-stage processing step, the workpiece block to a position deeper than the position of the first-stage processing step to form a plurality of intersecting slits, thereby forming the plurality of pin fins, wherein
widths of the slits formed by cutting in the first-stage processing step are set greater than widths of the slits formed by cutting in the second-stage processing step.

13. The method according to claim 12, further comprising
a cut-off step of removing, before the first-stage processing step, a portion including a side surface of the workpiece block in an area of a peripheral edge portion of the workpiece block, the area being where the slits are not to be formed.

14. The method according to claim 12, wherein
in at least one of the first-stage processing step and the second-stage processing step, cutting is performed in two or more steps, each with a different insertion depth from the end surface of the workpiece block.

15. The method according to claim 12, wherein
after the plurality of intersecting slits are formed in the first-stage processing step, the plurality of intersecting slits are formed in the second-stage processing step.
